# EUROPEAN PATENT SPECIFICATION

(11) **EP 3 871 919 B1**
(45) Date of publication and mention of the grant of the patent: **06.04.2022**
(21) Application number: 20159189.8
(22) Date of filing: 25.02.2020
(51) Int. Cl.: B60L 3/12, B60L 58/16, B60L 58/21, G01R 31/392, G01R 31/396, G01R 31/382, G01R 31/3842, H01M 10/48, H02J 7/00

(54) **METHOD AND DETECTION UNIT FOR DETECTING INHOMOGENEOUS CELL PERFORMANCE OF A BATTERY SYSTEM**
VERFAHREN UND DETEKTIONSEINHEIT ZUR ERKENNUNG EINER INHOMOGENEN ZELLLEISTUNG EINES BATTERIESYSTEMS
PROCÉDÉ ET UNITÉ DE DÉTECTION PERMETTANT DE DÉTECTER LA PERFORMANCE D'UNE CELLULE NON HOMOGÈNE D'UN SYSTÈME DE BATTERIE

(43) Date of publication of application: 01.09.2021
(73) Proprietor: Samsung SDI Co., Ltd., Gyeonggi-do 17084 (KR)
(72) Inventor: Doczy, Dr. Stefan, 8054 Pirka (AT)
(74) Representative: Gulde & Partner

(56) References cited:
- EP-A1- 2 573 578
- WO-A1-2013/047400
- WO-A1-2019/111045
- JP-A- 2002 272 011
- US-A1- 2011 313 613
- US-A1- 2014 339 891

## Description

### Field of the Invention

The present invention relates to a method and a detection unit for detecting inhomogeneous cell performance of a battery system. Further, the invention relates to an electrical vehicle with such a detection unit.

### Technological Background

In recent years, vehicles have been developed using electric power as a source of motion. An electric vehicle is an automobile that is powered by an electric motor using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while highcapacity rechargeable batteries are used as the power supply for hybrid vehicles and the like.

Rechargeable batteries may be used as a battery module formed of a plurality of unit battery cells coupled in series and/or in parallel so as to provide a high energy density, in particular for motor driving of a hybrid vehicle. A battery module may be formed by interconnecting the electrode terminals of the plurality of unit battery cells depending on a required amount of power and in order to realize a high-power rechargeable battery. The cells can be connected in series, parallel or in a mixture of both to deliver the desired voltage, capacity, or power density. Components of battery packs include the individual battery modules and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, potential electrical performance, charging ability and internal resistance as well as actual or predicted power demands or surpluses of the consumers.

Battery systems usually comprise a battery control for processing the aforementioned information. The battery control may comprise controllers of the various electrical consumers and contain suitable internal communication busses, e.g. a SPI or CAN interface. The battery control may further communicate with battery submodules, for example with cell supervision circuits or cell connection and sensing units. Thus, the battery control may be provided for managing the battery stack, such as by protecting the battery from operating outside its safe operating area, monitoring its state, calculating secondary data, reporting that data, controlling its environment, authenticating it and/or balancing it.

A diagnosis function should be capable of determining the present ageing status of a battery system. The ageing status of the battery is described by the capacity, which is related to the energy content of the battery, on the one hand and by the internal resistance, which is related to the power ability of the battery, on the other hand. The presented method is used to determine ageing mechanisms of the internal resistance. To be able to predict the present power ability of the system based on the determined cell resistance the current has to reach a certain amount. During usage of the battery the cells are subject to ageing and the resistance is growing. Also, at lower temperatures, the resistance is higher compared to standard conditions, e.g. 25°C. Therefore, the condition for the amount of current is critical because the cell voltage limit can be reached prior to a successful resistance determination.

US 2011/0313613 A1 and US 2014/0339891 A1 both disclose methods to control the charging or discharging current when an average current is above a limit, wherein the limit is based on the maximum or minimum cell voltage, respectively. WO 2019/111045 A1 discloses a battery system and a control method in which an internal resistance of blocks of battery cells is used to determine a protection current. JP 2002-272011 A discloses a charge-and-discharge apparatus to determine an input or output power considering internal resistance.

The internal resistance of a cell of a battery system is conventionally determined according to testing methods as described in ISO standards. The internal resistance is used to characterize the power ability of the cell and is dependent on temperature, state of charge, applied current, duration of applied current, ageing status of the cell and previous usage of the cell. Therefore, the internal resistance can be used to characterize the ageing status of the cell as long as the defined pulse duration and the reference ageing behavior according to temperature, state of charge, applied current is precisely known.

For expected normal behavior the internal resistance will only change slowly. The resistance growth will of course depend on the usage of the battery, but assuming 30% increase over 6 years this refers to a slowly changing parameter. Therefore the determination frequency is allowed to be low, for example only once every quarter of a year, but the necessary determination accuracy must be high.

A different situation occurs when unexpected limitations for example during usage in the powertrain of the vehicle are caused by the battery system. Rapid performance degradation due to ageing may occur at almost every longer parking situation. A possible observed error mode may be the exposure of the cell or some cells to a very high temperature, for example to 60°C, which may cause rapid increase of internal resistance due to electrolyte decomposition. Another possible observed error may be a high self-discharge for example caused by dendrites growth in response to lithium plating due to battery usage or metallic particle contamination during cell manufacturing.

It is thus an object of the present invention to overcome or reduce at least some of the drawbacks of the prior art and to provide a method of detecting inhomogeneous cell performance which has high availability, allows high testing frequency and is applicable also for low current conditions and is able to identify weakly performing individual cells among a plurality of battery cells.

### Summary of Invention

Embodiments of the present disclosure seek to solve at least one of the problems existing in the prior art to at least some extent.

In particular, a method for detecting inhomogeneous cell performance of a battery system for a vehicle is provided according to claim 1. The invention is defined in the appended claims.

The predetermined threshold value is above 1, preferably set to 2 or may also be for example 1.5 or 2.5, but the invention is not restricted to a particular threshold value. The number of battery cells may be 6, 12, 16, 24, but also here the invention is not restricted thereto. Averages throughout the application may be preferably arithmetic averages. A ratio is in other words a division. An inhomogeneous cell performance may be present, when one or a small fraction of battery cells have a higher internal resistance than the major part of battery cells.

The used resistance ratios as defined are highly sensitive for rapid ageing of an individual battery cell or a small group of cells among a plurality of cells, for example due to high local temperature exposure or self-discharge for example due to metallic contamination or dendrites growth caused by lithium plating. Thus, inhomogeneous cell performance is readily detected and the above error modes identifiable. Further, the invention allows identifying ageing in charging and discharging directions. For example, a discharging resistance ratio may be within the allowable range or vice versa, but the charging resistance ratio may already be above the threshold such that early identification is provided. The invention using the resistance ratio has furthermore the advantage that the availability of the diagnosis function is improved, as the determination can be done with higher frequency and the ratio is more robust as it permits a wider current and temperature range while still providing sufficient accuracy compared to known procedures where the mere inner resistance is used to determine ageing. That means that if due to high cell resistance the current is limited a resistance ratio according to the invention may still be determined even if current conditions for determination of cell resistances are not fulfilled. The invention is suitable in field application.

The determining of the charging resistance ratio is based on a determined average cell voltage, a determined average open circuit voltage and a determined maximum cell voltage among a plurality of cell voltages of the battery system, the determining of the discharging resistance ratio is based on a determined average cell voltage, a determined average open circuit voltage and a determined minimum cell voltage among a plurality of cell voltages of the battery system. The determination is based on cell voltages, only, and even if current conditions for cell resistance determination are not fulfilled, the above determination may still be performed. This for example improves availability.

In a preferred embodiment, the average open circuit voltage may be determined based on a determined average state of charge. The average state of charge can be readily determined to determine the required average open circuit voltage of the battery cells.

Preferably, determining the maximum cell voltage, the average cell voltage and the minimum cell voltage may be based on measured individual cell voltages of the battery cells. The individual voltages may be determined for example by voltage sensors. The average may be determined by determination of the arithmetic mean of the cell voltages. Maximum and minimum cell voltage may for example be retrieved from a vector comprising all measured cell voltages. Preferably, the measurement of the cell voltages should be synchronically performed, for example within a time window of 100ms but also shorter or longer time windows are possible.

The determining of the charging resistance ratio comprises calculating the fraction (uCellMax - uOCV) / (uCellAvg - uOCV) and wherein determining the discharging resistance ratio comprises calculating the fraction (uOCV - uCellMin) / (uOCV - uCellAvg). The determination does not directly require the charging current or the discharging current and is thus more robust with respect to lower currents or irregular current pulses.

Preferably, the method may comprise determining at least one influence quantity for the determination of the charging resistance ratio and/or the discharging resistance ratio and determining if the at least one influence quantity fulfills a limit condition, and perform the steps of determining that the battery system is in a non-degraded state or in a degraded state only, if the limit condition is fulfilled. Reliability of the determination is increased leading to a robust determination of ageing. An influence quantity is referred to as a quantity that affects the quality of the determination of the particular resistance ratios. An unnecessary exchange of the battery system in response to a wrong determination is thereby prevented. Validation of the determination is provided.

In a preferred embodiment, an influence quantity may be an integrated current, and a limit condition is fulfilled, when a determined integrated charging current is equal or above a charging current limit and/or when an integrated discharging current is equal or below an integrated discharging current limit. A defined state of the battery system may be reached by fulfilling the criterion before evaluating the measurement. Also, before evaluating the measurement, sufficient charge reversal may have occurred to improve determination quality. Preferably, an influence quantity may be a determined charging current and/or discharging current, and a limit condition is fulfilled, when the modulus of the determined current is between a lower current limit and an upper current limit. In comparison to mere resistance measurement, the lower current limit may be set substantially lower as the present determination of the resistance ratio is more robust towards small currents and/or irregular current pulses. For example, the lower current limit may be 10A or even less or 5A or less. Such limit may still generate significant voltage response. For example, the maximum discharge current may be approximately 300A, the maximum charge current may be approximately 200A, a single cell resistance approximately 1,5mOhm.

In a preferred embodiment, an influence quantity may be a determined average state of charge, and a limit condition is fulfilled, when the determined average state of charge is between a lower state of charge limit and an upper state of charge limit. An upper state of charge limit may be for example 90%, or 80% and a lower average state of charge ratio may be 10% or 20%, but the invention is not restricted thereto. Such boundary values may ensure a high measurement precision for determining inhomogeneous cell performance.

Preferably, an influence quantity is a determined average temperature, and a limit condition is fulfilled, when the average temperature is between a lower temperature limit and an upper temperature limit. A lower temperature limit may be for example -20°C or -10°C but the invention is not restricted thereto. An upper temperature limit may be for example 50°C, but the invention is not restricted thereto. For too high average temperatures, the battery cells may be homogeneously affected and individual weakly performing cells may not be sufficiently detectable. The average ensures that beside a local high temperature at a single cell or a small group of cells, the average temperature may still fulfil the condition.

In a preferred embodiment, an influence quantity may be a first charging voltage difference between the minimum cell voltage among a plurality of cell voltages of the battery system and the average open circuit voltage upon charging and/or a second discharging voltage difference between the average open circuit voltage upon discharging and the maximum cell voltage among a plurality of cell voltages, and a limit condition is fulfilled, when the first charging voltage difference is above a first charging voltage difference limit and/or the second discharging voltage difference is above a second discharging voltage difference limit. The condition may ensure that inhomogeneous behaviour can be detected. The criterion may comprise that discharging and charging cause different response and thus actually the fulfilment of two criteria may be checked. The voltage difference limits for the cell voltage spread may be about 50mV, 30mV or 20mV, but the invention is not restricted thereto.

Preferably, the determining of the charging resistance ratio and/or the discharging resistance ratio may be repeated at every drive cycle. Thereby, observation can be done with high frequency and weak performance of individual cells be rapidly detected.

In another aspect of the invention, a detection unit for detecting inhomogeneous cell performance of a battery system comprising a plurality of battery cells is disclosed, wherein the detection unit is configured to perform the above described method according to the various embodiments. A detection unit may for example be a processor unit, in particular for example a microprocessor, a processor or a CPU or the like. The detection unit may comprise suitable means to perform the corresponding method steps.

The detection unit may comprise a determination unit configured to determining a charging resistance ratio, which is the ratio of a maximum cell charging resistance of a battery cell among a plurality of battery cells and an average cell charging resistance of the plurality of battery cells, each determined in response to a charging current applied to the battery cells; and configured to determining a discharging resistance ratio, which is the ratio of a maximum cell discharging resistance of a battery cell among a plurality of battery cells and the average cell discharging resistance of the battery cells, each determined in response to a discharging current applied to the battery cells. The detection unit may further comprise a diagnostic unit configured to determine that the battery system is in a degraded ageing state, when at least one of the determined charging resistance ratio and the determined discharging resistance ratio is above a predetermined threshold value; and configured to determine that the battery system is in a non-degraded ageing state, when none of the determined charging resistance ratio and the determined discharging resistance ratio is above the predetermined threshold value. The advantages of the method as described above also apply to the detection unit.

In an example, the detection unit further comprises a condition check unit configured to determine at least one influence quantity for the determination of the charging resistance ratio and/or the discharging resistance ratio, and transmit a control signal to the diagnostic unit indicative of if the at least one influence quantity fulfills a limit condition, wherein the diagnostic unit is configured to perform the steps of determining that the battery system in a non-degraded state or in a degraded state, only when the control signal is indicative of that the limit condition is fulfilled. Also here, accuracy of the measurement using the resistance ratio is ensured.

In another aspect of the invention, a battery system is disclosed, comprising a plurality of battery cells and a detection unit according to the above embodiments and the embodiments as described in the following.

In another aspect of the present invention an electric vehicle is provided which comprises a battery system according to one of the above described embodiments.

Further aspects of the present invention could be learned from the dependent claims or the following description.

### Brief Description of the Drawings

Features will become apparent to those of ordinary skill in the art by describing in detail exemplary embodiments with reference to the attached drawings in which:
- Fig. 1: illustrates a method and a detection unit according to an embodiment of the invention;
- Figs. 2 to 9: illustrate the method and condition check sub units performing particular condition tests according to embodiments of the invention; and
- Fig. 10: schematically illustrates a battery system according to an embodiment of the invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Unless otherwise noted, like reference numerals denote like elements throughout the attached drawings and the written description, and thus, descriptions thereof will not be repeated. In the drawings, the relative sizes of elements, layers, and regions may be exaggerated for clarity.

The terminology used herein is for the purpose of describing particular embodiments only and is not intended to be limiting of the present invention. As used herein, the term "and/or" includes any and all combinations of one or more of the associated listed items. Expressions such as "at least one of," when preceding a list of elements, modify the entire list of elements and do not modify the individual elements of the list.

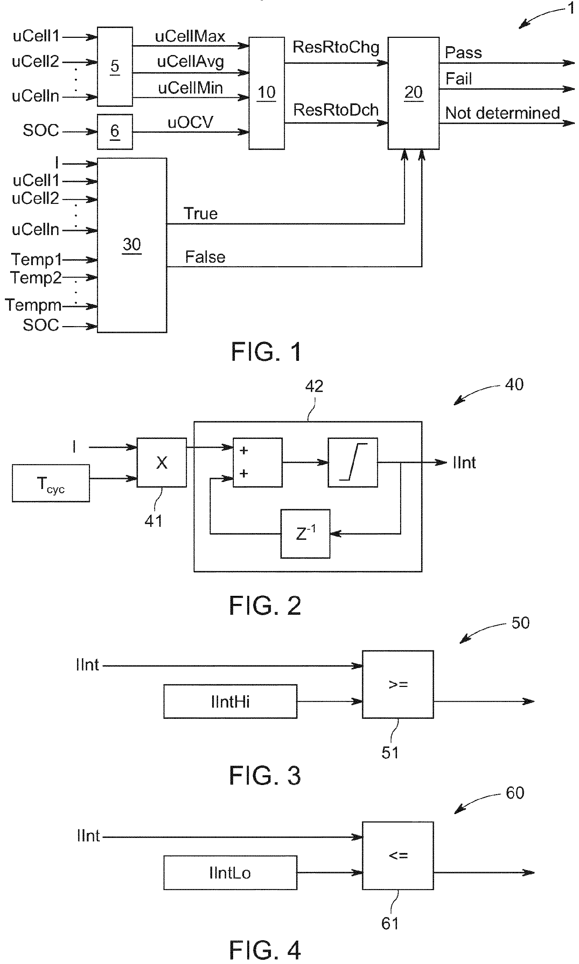

Fig. 1 shows a method and a corresponding detection unit 1 for detecting inhomogeneous cell performance of a battery system comprising a plurality of electrically interconnected battery cells. In the following, the method and the corresponding detection unit 1 are simultaneously described. In general, the detection unit 1 is configured to perform the method for detecting inhomogeneous cell performance of the battery system as described in the following.

The method comprises determining a charging resistance ratio ResRtoChg. The charging resistance ratio ResRtoChg is the ratio of a maximum cell charging resistance ResChgMax of a battery cell among a plurality of battery cells and an average cell charging resistance ResChgAvg of the plurality of battery cells, each determined in response to a charging current I applied to the battery cells. The average cell charging resistance ResChgAvg of the plurality of battery cells may be determined as arithmetic mean.

The method comprises additionally or as alternative the determining of a discharging resistance ratio ResRtoDch. The discharging resistance ratio ResRtoDch is the ratio of a maximum cell discharging resistance ResDchMax of a battery cell among a plurality of battery cells and the average cell discharging resistance ResDchAvg of the battery cells, each determined in response to a discharging current I applied to the battery cells. The charging current and the discharging current have the same reference sign, but the invention may also include embodiments in which they have different magnitude. The average cell discharging resistance ResDchAvg may be determined by an arithmetic mean.

In other words, the maximum cell discharging resistance ResDchMax is the discharging resistance of one particular cell that has the highest discharging resistance among the plurality of cells and the maximum cell charging resistance ResChgMax is the charging resistance of one particular cell that has the highest charging resistance among the plurality of cells.

In Fig. 1 it is further shown that a determination unit 10 may be configured to determine at least one of the above defined resistance ratios ResRtoChg, ResRtoDch, accordingly. The determination unit 10 may be configured to transmit signals indicative of the at least one of the determined resistance ratios ResRtoChg, ResRtoDch to a diagnostic unit 20, see Fig. 1. Based on the determined resistance ratios ResRtoChg, ResRtoDch the method comprises determining that the battery system is in a degraded ageing state, when at least one of the determined charging resistance ratio ResRtoChg and/or the determined discharging resistance ratio ResRtoDch is above a predetermined threshold value. The diagnostic unit 20, see Fig. 1, is configured to perform such determination. In such case, a control signal indicative of that the battery system is in a degraded ageing state may be generated. The latter is indicated by the signal "Fail" in Fig. 1.

Further, the method comprises the determining that the battery system is in a non-degraded ageing state, when none of the determined charging resistance ratio ResRtoChg and the determined discharging resistance ratio ResRtoDch is above the predetermined threshold value. In such case, a control signal indicative of that the battery system is in a non-degraded ageing state is generated by the diagnostic unit 20. The latter is indicated by the signal "Pass" in Fig. 1. The predetermined threshold value is above 1, preferably 2, but the invention is not restricted to a particular threshold value.

The invention includes as well the cases where only one of the resistance ratios is determined which is used alone for diagnosis. Preferably, both are used to provide an early identification of ageing, when only one of the ratios is at a given time above the threshold, see below.

The number of battery cells may be 4, 8, 12, 16, but also here the invention is not restricted thereto. The used resistance ratios as defined are highly sensitive for rapid ageing of an individual battery cell or a small group of cells among a plurality of cells, for example due to local high temperature exposure or high self-discharge for example due metallic contamination or dendrites growth caused by lithium plating. Thus, inhomogeneous cell performance and the above error modes are readily detected. Further, the invention allows identifying ageing in charging and discharging directions. For example, a discharging resistance ratio may be within the allowable range, but the charging resistance ratio may already be above the threshold such that early identification is provided.

The determining of the charging resistance ratio ResRtoChg is based on a determined average cell voltage uCellAvg, a determined average open circuit voltage uOCV and a determined maximum cell voltage uCellMax among a plurality of cell voltages uCell1, uCell2, uCelln of the battery system. Further, the determining of the discharging resistance ratio ResRtoDch is based on a determined average cell voltage uCellAvg, a determined average open circuit voltage uOCV and a determined minimum cell voltage uCellMin among a plurality of cell voltages uCell1, uCell2, uCelln of the battery system. A first voltage determination unit 5, see Fig. 1, may be provided and configured to determine the required maximum cell voltage uCellMax, the minimum cell voltage uCellMin and the average cell voltage uCellAvg. The first voltage determination unit 5 may be further configured to transmit a signal indicative of the determined voltages to the determination unit 10, see e.g. Fig. 1. The determining of the maximum cell voltage uCellMax, the average cell voltage uCellAvg, and the minimum cell voltage uCellMin may be based on measured individual cell voltages uCell1, uCell2, uCelln of the battery cells. These cell voltages may be determined by corresponding voltage sensors, not shown here, and signally transmitted to the first voltage determination unit 5. Arithmetic means may be used for determining the average cell voltages. Maximum and minimum cell voltage may be identified as the highest and lowest voltage from all cells, respectively. Preferably, the measurement of the cell voltages should be synchronically performed to guarantee comparability.

A second determination unit 6 may be provided, see Fig. 1, and may be configured to determine the average open circuit voltage uOCV based on a determined average state of charge SOC, see Fig. 1 in there. The second determination unit 6 may generate a signal indicative of the average open circuit voltage uOCV and transmit the signal to the determination unit 10. The state of charge SOC may be determined by conventional methods and transmitted to the second voltage determination unit 6.

The determination unit 10 is configured to determine the charging resistance ratio ResRtoChg by calculating the fraction (uCellMax - uOCV) / (uCellAvg - uOCV). Further, the determination unit 10 is configured to determine the discharging resistance ratio ResRtoDch by calculating the fraction (uOCV - uCellMin) / (uOCV - uCellAvg) without making explicit use of the current I indicating the robustness of the present invention towards low currents.

Preferably, the detection unit 1 may comprise a condition check unit 30. The condition check unit 30 may be configured to determine at least one influence quantity for the determination of the charging resistance ratio ResRtoChg and/or the discharging resistance ratio ResRtoDch and determining if the at least one influence quantity fulfills a limit condition. The influence quantity may affect the quality of the determination. In such case the detection performs the steps of determining that the battery system in a non-degraded state or in a degraded state only, when the limit condition for the influence quantity is fulfilled. In detail, the condition check unit 30 is configured to generate a signal indicative of that the condition or the conditions are fulfilled. Such signal may be referred to as "True", see Fig. 1. When more than one condition is checked, the signal may be referred to as "True" only, when all conditions are fulfilled. In the opposite case, the condition check unit 30 may be configured to generate a signal indicative of that the at least one condition is not fulfilled. Such signal may be hereby referred to as "False". The condition check unit 30 may be configured to transmit these signals to the diagnostic unit 20.

Then, in the case of a "True" signal received by the diagnostic unit 20, the diagnostic unit 20 may be configured to perform the determination as described above. In case of a "False" signal the diagnostic unit 20 may be configured to generate a signal indicative of that a determination could not be determined. The determination as described above may then be effectively prevented. Thereby, the quality of the determination of the resistance ratios is ensured.

The condition check unit 30 may be configured to receive several system quantities in order to check various limit conditions. In each of the following Figs. 2 to 9, according to preferred embodiments, several condition check sub units 40, 50, 60, 70, 80, 90, 100, 110 are disclosed. Each of the condition check sub units 40, 50, 60, 70, 80, 90, 100, 110 as described in the following Figs. 2 to 9 are configured to check a particular limit condition. The condition check unit 30 may comprise one or more than one or any combination of the condition check sub units 40, 50, 60, 70, 80, 90, 100, 110 as described in the following with respect to each of the Figs. 2 to 9.

Figs. 2 to 4 shows a preferred method step wherein the at least one influence quantity comprises an integrated current IInt. For determination of this quantity an integrating unit 40 may be provided. The integrating unit 40 may be configured to receive an applied current I. The integrating unit 40 may comprise a multiplicator 41 configured to multiply the current I with a cycle time Tcyc, e.g. for dimensional normalization but the invention is not restricted thereto and this step may be omitted in other embodiments. The integrator unit 40 may comprise a limited integrator 42. The limited integrator 42 may be configured to integrate the current I overtime resulting in an integrated current IInt within an upper and lower limit.

In the Figs. 3 and 4 the conditions are illustrated. In Fig. 3 a first integrated current condition check unit 50 may be provided which may comprise a first current condition comparator 51. The limit condition may be fulfilled, when a determined integrated charging current IInt is equal or above a charging current limit IIntHi. The integrated charging current IInt limit may be for example between 20As or 30As, but the invention is not restricted thereto.

In Fig. 4 a second integrated current condition check unit 60 may be provided which may comprise a second current condition comparator 61. The limit condition may be fulfilled, when a determined integrated discharging current IInt is equal or below a discharging current limit IIntLo. The integrated discharging current limit IIntLo may be for example between -20As and -30As, but the invention is not restricted thereto. By the conditions of Figs. 3 and 4 a defined state of the battery system may be reached before performing the measurement and sufficient charge reversal have been taken place.

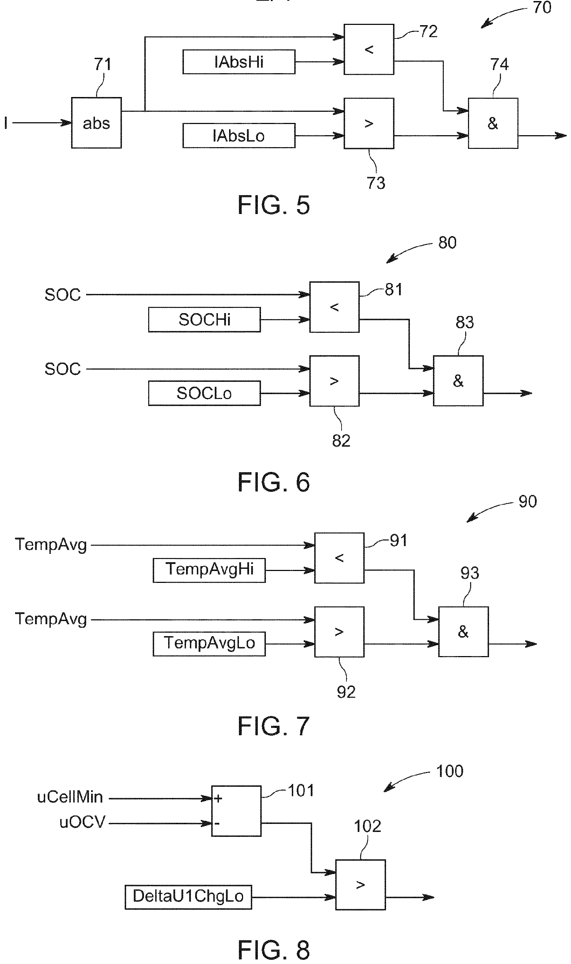

Fig. 5 shows another preferred method step wherein the at least one influence quantity comprises a charging current I and/or discharging current I. Therefore, a current condition check unit 70 may be provided. The current condition check unit 70 may be configured to receive the determined charging current I and/or the discharging current I as input. A modulus operator 71 may be provided to determine the modulus of the current I. A first current comparator 72 may be provided and configured to determine if the modulus of the current I is below an upper current limit IAbsHi. A second current comparator 73 may be provided and configured to determine if the modulus of the current I is above a lower current limit IAbsLo. An and-operator 74 may be configured to receive the output signals of the comparators 72, 73 and be configured to determine that the modulus of the determined current I is both between a lower current limit IAbsLo and an upper current limit IAbsHi. Then, the limit condition may be fulfilled. In other embodiments, only a lower current limit may be used. The lower current limit IAbsLo may be substantially lower than for conventional cell resistance determination, for example IAbsLo may be 5A or 10A, but the invention is not restricted thereto.

Fig. 6 shows another preferred method step wherein the at least one influence quantity comprises a determined state of charge SOC. Therefore, a state of charge condition check unit 80 may be provided. The state of charge condition check unit 80 may be configured to receive the state of charge SOC of the battery cells. The state of charge condition check unit 80 may comprise a first state of charge comparator 81. The first state of charge comparator 81 may be configured to determine if the state of charge SOC is below an upper state of charge limit SOCHi. The state of charge condition check unit 80 may comprise a second state of charge comparator 82. The second state of charge comparator 82 may be configured to determine if the state of charge SOC is above a lower state of charge limit SOCLo.

An and-operator 83 may be configured to receive the output signals of the comparators 81, 82 and configured to determine that the state of charge SOC is between a lower state of charge limit SOCLo and an upper state of charge limit SOCHi. Then, the limit condition may be fulfilled. This condition may ensure the quality of the resistance ratio determination.

Fig. 7 shows another preferred method step wherein the at least one influence quantity comprises a determined average temperature TempAvg. The determined average temperature TempAvg is hereby the average of measured cell temperatures Temp1, Temp2, Tempm at the respective battery cells. Therefore, a temperature condition check unit 90 may be provided. The temperature condition check unit 90 may be configured to receive the average temperature TempAvg of the battery cells. The temperature condition check unit 90 may comprise a first temperature comparator 91. The first temperature comparator 91 may be configured to determine if the temperature TempAvg is below an upper temperature limit TempAvgHi. The temperature condition check unit 90 may comprise a second temperature comparator 92. The second temperature comparator 92 may be configured to determine if the temperature TempAvg is above a lower temperature limit TempAvgLo.

An and-operator 93 may be configured to receive the output signals of the comparators 91, 92 and configured to determine that the temperature TempAvg is between a lower temperature limit TempAvgLo and an upper temperature limit TempAvgHi. Then, the limit condition may be fulfilled. Preferably, boundaries for lower temperature limit TempAvgLo may be at -20°C, which is lower than in conventional cell resistance determination. A too high temperature, 55°C may be an upper limit, would lead to simultaneous degradation and thus not to a signature of inhomogeneous cell performance.

Fig. 8 shows another preferred method step wherein the at least one influence quantity comprises a first charging voltage difference between the minimum cell voltage uCellMin among a plurality of cell voltages uCell1, uCell2, uCelln of the battery system and the average open circuit voltage uOCV upon charging. Therefore, a first voltage difference condition check unit 100 may be provided. The first voltage difference condition check unit 100 may be configured to receive the minimum cell voltage uCellMin among a plurality of cell voltages uCell1, uCell2, uCelln and the average open circuit voltage uOCV.

The first voltage difference condition check unit 100 may comprise a subtracter 101 configured to determine the difference between the minimum cell voltage uCellMin among a plurality of cell voltages uCell1, uCell2, uCelln of the battery system and the average open circuit voltage uOCV upon charging. The first voltage difference condition check unit 100 may comprise a first voltage comparator 102. The first voltage comparator 102 may be configured to determine if the first charging voltage difference is above a first voltage charging difference limit DeltaU1ChgLo. The limit condition may be fulfilled, when the first charging voltage difference is above the first voltage difference limit DeltaU1 ChgLo. The first voltage difference limit DeltaU1ChgLo may be preferably 20 mV, 30 mV or 50 mV.

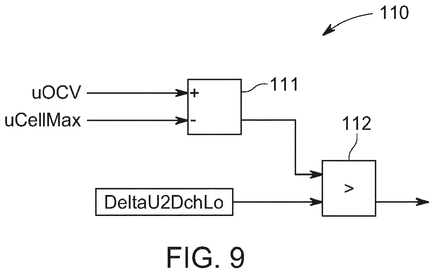

Fig. 9 shows yet another preferred method step wherein the at least one influence quantity comprises a second discharging voltage difference between the average open circuit voltage uOCV upon discharging and the maximum cell voltage uCellMax among a plurality of cell voltages uCell1, uCell2, uCelln.

Therefore, a second voltage difference condition check unit 110 may be provided. The second voltage difference condition check unit 110 may be configured to receive the maximum cell voltage uCellMax among a plurality of cell voltages uCell1, uCell2, uCelln and the average open circuit voltage uOCV upon discharging.

The second voltage difference condition check unit 110 may comprise a subtracter 111 configured to determine the difference between the average open circuit voltage uOCV upon discharging and the maximum cell voltage uCellMax among a plurality of cell voltages uCell1, uCell2, uCelln of the battery system. The second voltage difference condition check unit 110 may comprise a second voltage comparator 112. The second voltage comparator 112 may be configured to determine if the second voltage difference is above a second discharging voltage difference limit DeltaU2DchLo. The limit condition is fulfilled, when the second discharging voltage difference is above the second discharging voltage difference limit DeltaU2DchLo. The second voltage difference limit DeltaU2DchLo may be preferably 20 mV, 30 mV or 50 mV.

The determining of the charging resistance ratio ResRtoChg and/or the discharging resistance ratio ResRtoDch may be repeated at every drive cycle.

These influence quantities refer to the most important influence quantities, but the invention is not restricted thereto and further influence quantities may be used.

In embodiments, the condition check unit 30 comprises any one of the described condition check sub units 40, 50, 60, 70, 80, 90, 100, 110 corresponding to the examples disclosed in each of the Figures 2 to 9. In embodiments, the condition check unit 30 comprises only one or a plurality of condition check sub units 40, 50, 60, 70, 80, 90, 100, 110 selected among the condition check sub units 40, 50, 60, 70, 80, 90, 100, 110 of the Figs. 2 to 9. The condition check unit 30 may comprise each combinations of the condition check sub units 40, 50, 60, 70, 80, 90, 10, 110. The selection may depend on the influence quantities to be taken into account to ensure the quality of the determination.

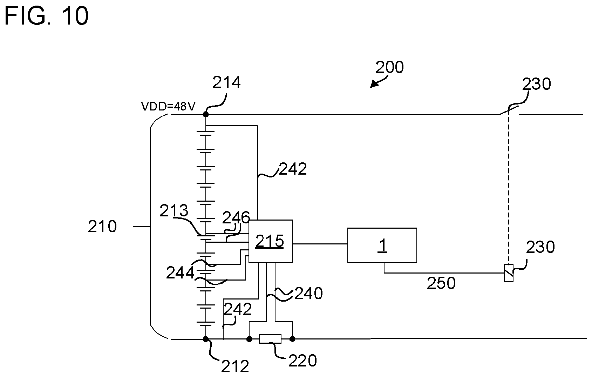

Fig. 10 shows a battery system 200 according to an example embodiment of the invention. The battery system 200 may comprise a plurality of battery cells 213. For example, the plurality of battery cells 214 may form a battery cell stack 210 generating a system voltage VDD which may be for example 48V but the invention is not restricted thereto.. A first node 212 may be grounded and a second node 214 may be on the high voltage VDD. The number of battery cells 213 may be 4, 8 or 12, the latter as in the present example, but the invention is not restricted thereto. Each of the battery cells 213 may provide a voltage of 4 V only for example. Further, the battery cells 213 may be stacked in series or in parallel, but the invention is not restricted thereto and also other configurations may be possible.

The battery system 200 may comprise suitable sensor means 215 to sense the required input quantities as required in the context of the previous Figs. 1 to 9, for example, cell voltages, cell temperatures, charging/discharging current, see above. For example, the sensor means 215 may be an analog front end, AFE. For example, voltage measurement lines for the system voltage VDD, temperature measurement lines 246 for a cell temperature and cell voltage measurement lines 244 for cell voltages may be provided to sense the required input quantities. A shunt 220 may be further disclosed and current measurement lines 240 to obtain signals indicative of the current via the shunt 220 may be provided, for example. Further, a detection unit 1 for detecting inhomogeneous cell performance is disclosed according to the various embodiments as described above. The detection unit 1 may receive the measured quantities from the sensor means 215. In other embodiments, the sensor means 215 may be part of the detection unit 1. The detection unit 1 may be configured to generate a control signal 250, for example to control a power switch 230 or for replacement of individual battery cells or other applications, based on a determination result of determining the inhomogeneous cell performance.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

### Reference signs

- 1: detection unit

- 5: first voltage determination unit
- 6: second voltage determination unit

- 10: determination unit

- 20: diagnostic unit

- 30: condition check unit

- 40: integrating unit
- 41: multiplicator
- 42: limited integrator

- 50: first integrated current condition check unit
- 51: first integrated current comparator

- 60: second integrated current condition check unit
- 61: second integrated current comparator

- 70: current condition check unit
- 71: modulus operator
- 72: first current comparator
- 73: second current comparator
- 74: and-operator

- 80: state of charge condition check unit
- 81: first state of charge comparator
- 82: second state of charge comparator
- 83: and-operator
- 90: temperature condition check unit
- 91: first temperature comparator
- 92: second temperature comparator
- 93: and-operator

- 100: first voltage difference condition check unit
- 101: subtracter
- 102: first voltage comparator

- 110: second voltage difference condition check unit
- 111: subtracter
- 112: second voltage comparator

- 200: battery system
- 210: battery cell stack
- 212: first node
- 213: battery cell
- 214: second node
- 215: sensor means
- 220: shunt
- 230: power switch
- 240: current measurement line
- 242: voltage measurement line
- 244: cell voltage measurement line
- 246: temperature measurement line
- 250: control signal
- VDD: system voltage

- uCell1, uCell2, uCelln: cell voltage
- uCellAvg: average cell voltage

- Temp1, Temp2, Tempm: cell temperature
- TempAvg: average temperature
- ResRtoChg: charging resistance ratio
- ResChgMax: maximum cell charging resistance
- ResChgAvg: average cell charging resistance

- ResRtoDch: discharging resistance ratio
- ResDchMax: maximum cell discharging resistance
- ResDchAvg: average cell discharging resistance

- I: charging current/discharging current
- IAbsLo: lower current limit
- IAbsHi: upper current limit

- IInt: integrated current
- IIntHi: charging integrated current limit
- IIntLo: discharging integrated current limit

- SOC: average state of charge
- SOCLo: lower state of charge limit
- SOCHi: upper state of charge limit
- uOCV: average open circuit voltage

- TempAvg: average temperature
- TempAvgLo: lower temperature limit
- TempAvgHi: upper temperature limit

- DeltaU1ChgLo: first charging voltage difference limit
- DeltaU2DchLo: second discharging voltage difference limit

## Claims

1. A method for detecting inhomogeneous cell performance of a battery system comprising a plurality of battery cells, comprising:
- determining a charging resistance ratio (ResRtoChg), which is the ratio of a maximum cell charging resistance (ResChgMax) of a battery cell among a plurality of battery cells and an average cell charging resistance (ResChgAvg) of the plurality of battery cells, each determined in response to a charging current (I) applied to the battery cells; and
determining a discharging resistance ratio (ResRtoDch), which is the ratio of a maximum cell discharging resistance (ResDchMax) of a battery cell among a plurality of battery cells and the average cell discharging resistance (ResDchAvg) of the battery cells, each determined in response to a discharging current (I) applied to the battery cells, and
wherein the determining of the charging resistance ratio (ResRtoChg) is based on a determined average cell voltage (uCellAvg), a determined average open circuit voltage (uOCV) and a determined maximum cell voltage (uCellMax) among a plurality of cell voltages (uCell1, uCell2, uCelln) of the battery system, the determining of the discharging resistance ratio (ResRtoDch) is based on a determined average cell voltage (uCellAvg), a determined average open circuit voltage (uOCV) and a determined minimum cell voltage (uCellMin) among a plurality of cell voltages (uCell1, uCell2, uCelln) of the battery system, and wherein determining the charging resistance ratio (ResRtoChg) comprises calculating the fraction (uCellMax - uOCV) / (uCellAvg - uOCV) and wherein
determining the discharging resistance ratio (ResRtoDch) comprises calculating the fraction (uOCV - uCellMin) / (uOCV - uCellAvg); and
- determining that the battery system is in a degraded ageing state, when at least one of the determined charging resistance ratio (ResRtoChg) and the determined discharging resistance ratio (ResRtoDch) is above a predetermined threshold value; and
- determining that the battery system is in a non-degraded ageing state, when none of the determined charging resistance ratio (ResRtoChg) and the determined discharging resistance ratio (ResRtoDch) is above the predetermined threshold value.

2. The method of claim 1, wherein the average open circuit voltage (uOCV) is determined based on a determined average state of charge (SOC).

3. The method of one of the claims 1 to 2, wherein determining the maximum cell voltage (uCellMax), the average cell voltage (uCellAvg), and the minimum cell voltage (uCellMin) is based on measured individual cell voltages (uCell1, uCell2, uCelln) of the battery cells.

4. The method of one of the claims 1 to 3, further comprising determining at least one influence quantity for the determination of the charging resistance ratio (ResRtoChg) and/or the discharging resistance ratio (ResRtoDch) and determining if the at least one influence quantity fulfills a limit condition, and perform the steps of determining that the battery system in a non-degraded state or in a degraded state only, when the limit condition is fulfilled.

5. The method of claim 4, wherein the at least one influence quantity comprises an integrated current (IInt), and the limit condition is fulfilled, when a determined integrated charging current (IInt) is equal or above a charging current limit (IIntHi) and/or when an integrated discharging current (IInt) is equal or below an integrated discharging current limit (IIntLo).

6. The method of one of the claims 4 to 5, wherein the at least one influence quantity comprises determined charging current (I) and/or discharging current (I), and the limit condition is fulfilled, when the modulus of the determined current (I) is between a lower current limit (IAbsLo) and an upper current limit (lAbsHi).

7. The method of one of the claims 4 to 6, wherein the at least one influence quantity comprises a determined average state of charge (SOC), and the condition is fulfilled, when the determined average state of charge (SOC) is between a lower state of charge limit (SOCLo) and an upper state of charge limit (SOCHi).

8. The method of one of the claims 4 to 7, wherein the at least one influence quantity comprises a determined average temperature (TempAvg), and the limit condition is fulfilled, when the average temperature (TempAvg) is between a lower temperature limit (TempAvgLo) and an upper temperature limit (TempAvgHi).

9. The method of one of the claims 4 to 8, wherein the at least one influence quantity is a first charging voltage difference between the minimum cell voltage (uCellMin) among a plurality of cell voltages (uCell1, uCell2, uCelln) of the battery system and the average open circuit voltage (uOCV) upon charging and/or a second discharging voltage difference between the average open circuit voltage (uOCV) upon discharging and the maximum cell voltage (uCellMax) among a plurality of cell voltages (uCell1, uCell2, uCelln), and the limit condition is fulfilled, when the first charging voltage difference is above a first charging voltage difference limit (DeltaU1ChgLo) and/or the second discharging voltage difference is above a second discharging voltage difference limit (DeltaU2DchLo).

10. The method of one of the claims 1 to 9, wherein the determining of the charging resistance ratio (ResRtoChg) and/or the discharging resistance ratio (ResRtoDch) is repeated at every drive cycle.

11. Detection unit (1) for detecting inhomogeneous cell performance of a battery system comprising a plurality of battery cells, wherein the detection unit (1) is configured to perform the method according to one of the claims 1 to 10.

12. Battery system (200), comprising a plurality battery cells (213) and a detection unit (1) according to claim 11.

13. Electrical vehicle, comprising a battery system (200) according to claim 12.

## Patentansprüche

1. Ein Verfahren zur Erkennung einer inhomogenen Zellleistung eines Batteriesystems, das eine Vielzahl von Batteriezellen aufweist, aufweisend:
- Bestimmen eines Ladewiderstandsverhältnisses (ResRtoChg), das das Verhältnis eines maximalen Zellladewiderstands (ResChgMax) einer Batteriezelle aus einer Vielzahl von Batteriezellen und eines mittleren Zellladewiderstands (ResChgAvg) der Vielzahl der Batteriezellen ist, die jeweils in Reaktion auf einen an den Batteriezellen anliegenden Ladestrom (I) bestimmt werden; und
Bestimmen eines Entladewiderstandsverhältnisses (ResRtoDch), das das Verhältnis eines maximalen Zellentladewiderstands (ResDchMax) einer Batteriezelle aus einer Vielzahl von Batteriezellen und des mittleren Zellentladewiderstands (ResDchAvg) der Batteriezellen ist, die jeweils in Reaktion auf einen an den Batteriezellen anliegenden Entladestrom (I) bestimmt werden, und
wobei das Bestimmen des Ladewiderstandsverhältnisses (ResRtoChg) auf einer bestimmten mittleren Zellspannung (uCellAvg), einer bestimmten mittleren Leerlaufspannung (uOCV) und einer bestimmten maximalen Zellspannung (uCellMax) aus einer Vielzahl von Zellspannungen (uCell1, uCell2, uCelln) des Batteriesystems basiert, wobei das Bestimmen des Entladewiderstandsverhältnisses (ResRtoDch) auf einer bestimmten mittleren Zellspannung (uCellAvg), einer bestimmten mittleren Leerlaufspannung (uOCV) und einer bestimmten minimalen Zellspannung (uCellMin) aus einer Vielzahl von Zellspannungen (uCell1, uCell2, uCelln) des Batteriesystems basiert, und
wobei das Bestimmen des Ladewiderstandsverhältnisses (ResRtoChg) das Berechnen des Anteils (uCellMax - uOCV) / (uCellAvg - uOCV) aufweist, und wobei das Bestimmen des Entladewiderstandsverhältnisses (ResRtoDch) das Berechnen des Anteils (uOCV - uCellMin) / (uOCV - uCellAvg) aufweist; und
- Bestimmen, dass das Batteriesystem in einem degradierten Alterungszustand ist, wenn zumindest eines des bestimmten Ladewiderstandsverhältnisses (ResRtoChg) und des bestimmten Entladewiderstandsverhältnisses (ResRtoDch) über einem vorbestimmten Schwellenwert liegt; und
- Bestimmen, dass das Batteriesystem in einem nicht-degradierten Alterungszustand ist, wenn keines des bestimmten Ladewiderstandsverhältnisses (ResRtoChg) und des bestimmten Entladewiderstandsverhältnisses (ResRtoDch) über dem vorbestimmten Schwellenwert liegt.

2. Das Verfahren nach Anspruch 1, wobei die mittlere Leerlaufspannung (uOCV) basierend auf einem bestimmten mittleren Ladezustand (SOC) bestimmt wird.

3. Das Verfahren nach einem der Ansprüche 1 bis 2, wobei das Bestimmen der maximalen Zellspannung (uCellMax), der mittleren Zellspannung (uCellAvg) und der minimalen Zellspannung (uCellMin) auf gemessenen einzelnen Zellspannungen (uCell1, uCell2, uCelln) der Batteriezellen basiert.

4. Das Verfahren nach einem der Ansprüche 1 bis 3, ferner aufweisend Bestimmen zumindest einer Einflussgröße für die Bestimmung des Ladewiderstandsverhältnisses (ResRtoChg) und/oder des Entladewiderstandsverhältnisses (ResRtoDch) und Bestimmen, ob die zumindest eine Einflussgröße eine Grenzbedingung erfüllt, und Durchführen der Schritte des Bestimmens, dass das Batteriesystem in einem nicht-degradierten Zustand oder in einem degradierten Zustand ist, nur dann, wenn die Grenzbedingung erfüllt ist.

5. Das Verfahren nach Anspruch 4, wobei die zumindest eine Einflussgröße einen integrierten Strom (IInt) aufweist und die Grenzbedingung erfüllt ist, wenn ein bestimmter integrierter Ladestrom (IInt) einer Ladestromgrenze (IIntHi) entspricht oder darüber liegt, und/oder wenn ein integrierter Entladestrom (IInt) einer integrierten Entladestromgrenze (IIntLo) entspricht oder darunter liegt.

6. Das Verfahren nach einem der Ansprüche 4 bis 5, wobei die zumindest eine Einflussgröße einen bestimmten Ladestrom (I) und/oder Entladestrom (I) aufweist und die Grenzbedingung erfüllt ist, wenn der Modul des bestimmten Stroms (I) zwischen einer unteren Stromgrenze (IAbsLo) und einer oberen Stromgrenze (IAbsHi) liegt.

7. Das Verfahren nach einem der Ansprüche 4 bis 6, wobei die zumindest eine Einflussgröße einen bestimmten mittleren Ladezustand (SOC) aufweist und die Bedingung erfüllt ist, wenn der bestimmte mittlere Ladezustand (SOC) zwischen einer unteren Ladezustandsgrenze (SOCLo) und einer oberen Ladezustandsgrenze (SOCHi) liegt.

8. Das Verfahren nach einem der Ansprüche 4 bis 7, wobei die zumindest eine Einflussgröße eine bestimmte mittlere Temperatur (TempAvg) aufweist und die Grenzbedingung erfüllt ist, wenn die mittlere Temperatur (TempAvg) zwischen einer unteren Temperaturgrenze (TempAvgLo) und einer oberen Temperaturgrenze (TempAvgHi) liegt.

9. Das Verfahren nach einem der Ansprüche 4 bis 8, wobei die zumindest eine Einflussgröße eine erste Ladespannungsdifferenz zwischen der minimalen Zellspannung (uCellMin) aus einer Vielzahl von Zellspannungen (uCell1, uCell2, uCelln) des Batteriesystems und der mittleren Leerlaufspannung (uOCV) bei Aufladung und/oder eine zweite Entladespannungsdifferenz zwischen der mittleren Leerlaufspannung (uOCV) bei Entladung und der maximalen Zellspannung (uCellMax) aus einer Vielzahl von Zellspannungen (uCell1, uCell2, uCelln) ist und die Grenzbedingung erfüllt ist, wenn die erste Ladespannungsdifferenz über einer ersten Ladespannungsdifferenzgrenze (DeltaU1ChgLo) liegt und/oder die zweite Entladespannungsdifferenz über einer zweiten Entladespannungsdifferenzgrenze (DeltaU2DchLo) liegt.

10. Das Verfahren nach einem der Ansprüche 1 bis 9, wobei das Bestimmen des Ladewiderstandsverhältnisses (ResRtoChg) und/oder des Entladewiderstandsverhältnisses (ResRtoDch) in jedem Fahrzyklus wiederholt wird.

11. Detektionseinheit (1) zur Erkennung einer inhomogenen Zellleistung eines Batteriesystems, das eine Vielzahl von Batteriezellen aufweist, wobei die Detektionseinheit (1) konfiguriert ist, um das Verfahren nach einem der Ansprüche 1 bis 10 durchzuführen.

12. Batteriesystem (200), aufweisend eine Vielzahl von Batteriezellen (213) und eine Detektionseinheit (1) nach Anspruch 11.

13. Elektrofahrzeug, aufweisend ein Batteriesystem (200) nach Anspruch 12.

## Revendications

1. Procédé permettant de détecter des performances non homogènes d'éléments d'un système de batterie comprenant une pluralité d'éléments de batterie, comprenant les étapes consistant à :
- déterminer un rapport de résistance de charge (ResRtoChg) qui est le rapport entre une résistance de charge maximale d'élément (ResChgMax) d'un élément de batterie parmi une pluralité d'éléments de batterie et une résistance de charge moyenne d'éléments (ResChgAvg) de la pluralité d'éléments de batterie, déterminées chacune en réponse à un courant de charge (I) appliqué aux éléments de batterie ; et
- déterminer un rapport de résistance de décharge (ResRtoDch) qui est le rapport entre une résistance de décharge maximale d'élément (ResDchMax) d'un élément de batterie parmi une pluralité d'éléments de batterie et la résistance de décharge moyenne d'éléments (ResDchAvg) des éléments de batterie, déterminées chacune en réponse à un courant de décharge (I) appliqué aux éléments de batterie, et
dans lequel la détermination du rapport de résistance de charge (ResRtoChg) est fondée sur une tension moyenne d'éléments (uCellAvg) déterminée, une tension en circuit ouvert moyenne (uOCV) déterminée et une tension maximale d'éléments (uCellMax) déterminée parmi une pluralité de tensions d'éléments (uCell1, uCell2, uCelln) du système de batterie, la détermination du rapport de résistance de décharge (ResRtoDch) est fondée sur une tension moyenne d'éléments (uCellAvg) déterminée, une tension en circuit ouvert (uOCV) moyenne déterminée et une tension minimale d'éléments (uCellMin) déterminée parmi une pluralité de tensions d'éléments (uCell1, uCell2, uCelln) du système de batterie, et
dans lequel la détermination du rapport de résistance de charge (ResRtoChg) comprend le calcul de la fraction (uCellMax - uOCV) / (uCellAvg - uOCV), et
dans lequel la détermination du rapport de résistance de décharge (ResRtoDch) comprend le calcul de la fraction (uOCV - uCellMin) / (uOCV - uCellAvg) ; et
- déterminer que le système de batterie est dans un état de vieillissement dégradé, lorsque au moins l'un du rapport de résistance de charge (ResRtoChg) déterminé et du rapport de résistance de décharge (ResRtoDch) déterminé est supérieur à une valeur de seuil prédéterminée ; et
- déterminer que le système de batterie est dans un état de vieillissement non dégradé, lorsque ni le rapport de résistance de charge (ResRtoChg) déterminé ni le rapport de résistance de décharge (ResRtoDch) déterminé ne sont supérieurs à la valeur de seuil prédéterminée.

2. Procédé selon la revendication 1, dans lequel la tension en circuit ouvert (uOCV) moyenne est déterminée sur la base d'un état de charge moyen déterminé (SOC).

3. Procédé selon l'une des revendications 1 et 2, dans lequel la détermination de la tension maximale d'éléments (uCellMax), de la tension moyenne d'éléments (uCellAvg) et de la tension minimale d'éléments (uCellMin) est fondée sur des tensions d'éléments individuels mesurées (uCell1, uCell2, uCelln) des éléments de batterie.

4. Procédé selon l'une des revendications 1 à 3, comprenant en outre l'étape consistant à déterminer au moins une grandeur d'influence pour la détermination du rapport de résistance de charge (ResRtoChg) et/ou du rapport de résistance de décharge (ResRtoDch), et l'étape consistant à déterminer si l'au moins une grandeur d'influence satisfait à une condition limite, et n'exécutant les étapes consistant à déterminer que le système de batterie est dans un état non dégradé ou dans un état dégradé que lorsque la condition limite est satisfaite.

5. Procédé selon la revendication 4, dans lequel l'au moins une grandeur d'influence comprend un courant intégré (IInt), et la condition limite est satisfaite lorsqu'un courant de charge intégré (IInt) déterminé est supérieur ou égal à une limite de courant de charge (IIntHi) et/ou lorsqu'un courant de décharge intégré (IInt) est inférieur ou égal à une limite de courant de décharge intégré (IIntLo) .

6. Procédé selon l'une des revendications 4 et 5, dans lequel l'au moins une grandeur d'influence comprend un courant de charge (I) et/ou un courant de décharge (I) déterminés, et la condition limite est satisfaite lorsque le module du courant (I) déterminé est compris entre une limite inférieure de courant (IAbsLo) et une limite supérieure de courant (IAbsHi).

7. Procédé selon l'une des revendications 4 à 6, dans lequel l'au moins une grandeur d'influence comprend un état de charge (SOC) moyen déterminé, et la condition est satisfaite lorsque l'état de charge (SOC) moyen déterminé est compris entre une limite inférieure d'état de charge (SOCLo) et une limite supérieure d'état de charge (SOCHi).

8. Procédé selon l'une des revendications 4 à 7, dans lequel l'au moins une grandeur d'influence comprend une température moyenne (TempAvg) déterminée, et la condition limite est satisfaite lorsque la température moyenne (TempAvg) est comprise entre une limite inférieure de température (TempAvgLo) et une limite supérieure de température (TempAvgHi).

9. Procédé selon l'une des revendications 4 à 8, dans lequel l'au moins une grandeur d'influence est une première différence de tension de charge entre la tension minimale d'éléments (uCellMin) parmi une pluralité de tensions d'éléments (uCell1, uCell2, uCelln) du système de batterie et la tension en circuit ouvert (uOCV) moyenne lors de la charge et/ou une seconde différence de tension de décharge entre la tension en circuit ouvert (uOCV) moyenne lors de la décharge et la tension maximale d'éléments (uCellMax) parmi une pluralité de tensions d'éléments (uCell1, uCell2, uCelln), et la condition limite est satisfaite lorsque la première différence de tension de charge est supérieure à une première limite de différence de tension de charge (DeltaU1ChgLo) et/ou que la seconde différence de tension de décharge est supérieure à une seconde limite de différence de tension de décharge (DeltaU2DchLo).

10. Procédé selon l'une des revendications 1 à 9, dans lequel la détermination du rapport de résistance de charge (ResRtoChg) et/ou du rapport de résistance de décharge (ResRtoDch) est répétée à chaque cycle de conduite.

11. Unité de détection (1) permettant de détecter des performances non homogènes d'éléments d'un système de batterie comprenant une pluralité d'éléments de batterie, où l'unité de détection (1) est configurée pour mettre en œuvre le procédé selon l'une des revendications 1 à 10.

12. Système de batterie (200) comprenant une pluralité d'éléments de batterie (213) et une unité de détection (1) selon la revendication 11.

13. Véhicule électrique comprenant un système de batterie (200) selon la revendication 12.
